# EUROPEAN PATENT APPLICATION

(11) **EP 2 552 182 A1**
(43) Date of publication of application: **30.01.2013**
(21) Application number: 11175915.5
(22) Date of filing: 29.07.2011
(51) Int. Cl.: H05K 7/20, F25B 7/00, F28D 15/02

(54) **Double-loop thermosiphon for cooling of electric and electronic components**

(71) Applicant: ABB Research Ltd., 8050 Zürich (CH)
(72) Inventor: Bergamini, Alessio, 24020 Ardesio (IT); Agostini, Francesco, 4800 Zofingen (CH); Habert, Mathieu, 8953 Dietikon (CH); Besana, Stefano, 24030 Terno d'Isola (IT); Kaufmann, Lilian, 5413 Birmenstorf (CH); Malinowski, Lukasz, 31-038 Krakow (PL)
(74) Representative: ABB Patent Attorneys

(57) **Abstract**

The present invention relates to the cooling of power electric and/or electronic components, in particular to a heat exchanger system (200) for moving heat from a heat source (120) comprising at least one of an electric and an electronic component (120). The heat exchanger system (200) comprises a first cooling circuit (210) that is formed as a loop-type thermo siphon comprising a first coolant with at least partially changes phases between the liquid state and a vaporous state in an operating state of the first cooling circuit (210) when heated up above a vaporization point of the first coolant. The first cooling circuit (210) has a first interface (212) for receiving a thermal load from the heat source (120) that is thermally connected to the first interface (212) and has a second interface (214) for releasing a major portion of said thermal load. The first interface (212) acts as a first evaporator (131) and the second interface (214) acts as a first condenser (133) in an operating state of the first cooling circuit (210). The heat exchanger system (200) further comprises a second cooling circuit (212) that is formed as a loop-type thermo siphon comprising a second coolant which at least partially changes phases between a liquid state and a vapor state, an operating state of the second cooling circuit (220) when heated up above a vaporization point of the second coolant. The second cooling circuit (212) has a third interface (216) that is thermally connected to the second interface (214). The second cooling circuit (220) has a fourth interface (218) for releasing the major portion of said thermal load taken up at the third interface (216). The third interface (216) acts as a second evaporator (212) and the fourth interface (218) acts as a second condenser (222) in an operating state of the second cooling circuit (212).

## Description

### FIELD OF THE INVENTION

The invention relates to the removal of heat from electric and electronic components. In particular, the invention relates to a heat exchanger system for removing heat from a heat source comprising at least one of an electric and electronic component, a switching module comprising a heat source and a first cooling circuit, a switching cabinet comprising the heat exchanger system, a method of manufacturing the heat exchanger system, and the use of the heat exchanger system.

### BACKGROUND OF THE INVENTION

In the field of electric, electronic, low, medium, and high voltage applications, cooling systems are widely used.

Electric and electronic devices must be cooled in operation in order to avoid excessive temperatures and consequently failure of the devices. Typical applications feature not only high rates of heat generation by the devices, but also high power densities, i. e. heat fluxes.

Air cooling systems for cooling electric or electronic devices with current ranges between a few hundred amperes and several thousands of amperes may consist of an array of fins extending from a base plate and may need a fan for forced convection, in order to reduce the thermal load of the electric or electronic devices and in order to dump the heat to a location distant to the electric or electronic devices. Circuit breakers may be cooled by natural convection.

### DESCRIPTION OF THE INVENTION

It may be seen as an object of the invention to provide for an improved, efficient and flexible heat removal from electric and electronic components.

This object is achieved by a heat exchanger system, a switching module comprising a heat source and a first cooling circuit, a switching cabinet comprising the heat exchanger system, a method of manufacturing the heat exchanger system, and a use of the heat exchanger system according to the independent claims. Further embodiments are evident from the dependent claims.

According to an embodiment of the invention, a heat exchanger system for removing heat from a heat source, comprising at least one of an electric and an electronic component is provided. The heat exchanger comprises a first cooling circuit that is formed as a loop-type thermosiphon comprising a first coolant which at least partially changes phases between a liquid state and a vaporous state in an operating state of the first cooling circuit when heated up above a vaporization point of the first coolant. The first cooling circuit has a first interface for receiving a thermal load from the heat source that is thermally connectable to the first interface and has a second interface for releasing a major portion of said thermal load. The first interface acts as a first evaporator, and the second interface acts as a first condenser in an operating state of the first cooling circuit. The heat exchanger system further comprises a second cooling circuit that is formed as a loop-type thermosiphon comprising a second coolant which at least partially changes phases between a liquid state and a vaporous state in an operating state of the second cooling circuit when heated up above a vaporization point of the second coolant. The second cooling circuit has a third interface that is thermally connected to the second interface and has a fourth interface for releasing the major portion of said thermal load taken up at the third interface. The third interface acts as a second evaporator, and the fourth interface acts as a second condenser in an operating state of the second cooling circuit.

The first coolant and the second coolant may remain separated of one another in an operating state of the heat exchanger system. More than one first cooling circuit and more than one second cooling circuit may be provided.

In other words, cooling of a heat source such as a circuit breaker or switching module in general and the transmission of the dissipated heat towards an external heat dumping device generally located at a cabinet side outside a cabinet in which the circuit breaker or switching module is installed or at a customer location where a suitable cooling is available are provided by a double-loop thermosiphon comprising a first cooling circuit and a second cooling circuit. The first cooling circuit or first loop is arranged at the level of the heat source, for example, the circuit breaker or switching module having one of an electric and an electronic component, and the second cooling circuit or second loop is arranged at cabinet level or generally at customer environment level. The condenser of the first cooling circuit directly exchanges heat with the evaporator of the second cooling circuit.

In the first cooling circuit, a selected fluid such as a refrigerant or a coolant may evaporate at a location identified as a first evaporator acting as a first interface in an operating state of the heat exchanger system. At the first evaporator side or first interface, the heat load generated by the heat source may be transferred by an evaporation process. The vapour afterwards moves toward the first condenser where it is brought back to liquid condition. The difference of density between the vapour phase and the liquid phase is driving the fluid or coolant in the first loop or first cooling circuit. The vapour and liquid phases are different phases in the same working fluid or coolant generally at saturated conditions. A major portion, e.g. more than 50%, of the heat load of the heat source is released by the second condenser acting as the second interface to a third interface acting as a second evaporator of the second cooling circuit. The heat load is then transferred to the second condenser acting as the fourth interface of the second cooling circuit by the evaporation process as described above applied to a second coolant. The second condenser releases the heat to ambient by exchanging heat with a third coolant such as air or water, for example. The fourth interface acting as the second condenser releases the major portion of the heat load received by the third interface at a suitable customer location away from the heat source such as outside a cabinet incorporating the heat source.

If it is desired to achieve a reliable and efficient way to transport heat from a heat source comprising electric or electronic components to a location where the heat can be easily dumped, such as a location outside a cabinet incorporating the heat source, this object may be achieved by the heat exchanger system mentioned above and in the following.

A first loop may be located at the heat source level, for example a circuit breaker level, and a second loop at a distance away from the heat source, for example at a cabinet level. The interface of the two systems is located at the condenser of the first loop and at the evaporator of the second loop. The evaporator of the second loop may be seen as the condenser of the first loop. The evaporating fluid of the second loop travels toward the condenser, which may be installed at an opportune customer location, and the liquid is driven back by gravity to the evaporator in an operating state of the heat exchanger system.

The nature of the heat exchanger system is such that the two fluids or in other words first and second coolants presented respectively in the two thermosiphons do not physically get in contact with each other. For this reason, the fluids of the two loops may be different in nature.

If it is desired to optimize the heat transfer between the two fluids or between the first coolant and the second coolant, the thermal resistance may be minimized in the heat exchanger system described above and in the following.

If it is desired to optimise or increase the efficiency of an exchange of a switching module with a heat source out of a higher unit in which the switching module is installed, this may be achieved by the heat exchanger system mentioned above and below, which may enable to omit a coolant (first and/or second coolant) handling comprising discharging the coolant and refilling a new coolant in the cooling circuit after the exchange.

This may result advantageously in that there is no danger of damaging or contaminating parts of the equipment of the switching module(s) and the cabinet by leaking coolant which may be another desired object of the invention. The cooling interface between the second and third interface may thus be a clean, mechanical interface as well as the interface between the heat source and the first interface.

Depending on the type of the switching modules the exchange of these modules may be required already after a few years of operation time. For the operator of the facility such a module exchange may result in that the operation of a facility has to be partly interrupted. By providing the heat exchanger system mentioned above and in the following, interrupting time at an exchange of the module(s) may be kept short and the exchange may also be performed in a simple and efficient manner by low-skilled employees, which may be another desired object of the invention.

If a simplified and more efficient manufacturing of the switching module and the incorporating unit or in other words higher unit of the switching module such as a cabinet is desired, this may be achieved by the heat exchanger system mentioned above and below, as the cabinet may be manufactured at a first location, the switching module(s) may be manufactured at a second location, and switching module(s) and cabinet may be mounted to each other at a third location of final assembly. Hence, the second and third interface is a thermal coupling that may be a mechanical coupling.

A switching module may comprise terminal links which extend through an enclosure of the switching module and which terminal links may operate as cooling elements such that a significant reduction of the temperature within the switching module may be achieved. Each of the terminal links may have a different electrical phase, such that three terminal links may have three different phases. The first interface acting as the first evaporator may be thermally connected to the terminal links for at least partially receiving a thermal load generated by the switching module from the terminal links in an operating state of the heat exchanger system.

According to an aspect of the invention, the third interface is detachable from the second interface.

If simple and efficient exchange or maintenance of the heat source(s) such as switching module(s) with either the first or the second cooling circuit is desired, this object may be achieved by providing such a heat exchanger system with a detachable third interface from a second interface, as an exchange of the first cooling circuit of the heat source, for example after a certain operation time of the latter, may be possible without changing the second cooling circuit of the cabinet, or/and vice-versa.

The first evaporator of the first cooling circuit may comprise at least one first evaporator conduit and the first condenser may comprise at least one first condenser conduit which is fluidly connected to the at least one first condenser conduit.

The second evaporator of the second cooling circuit may comprise at least one second evaporator conduit and the second condenser may comprise at least one second condenser conduit which is fluidly connected to the at least one second evaporator conduit.

The first and/or second evaporator may form a first and/or second evaporator section, and the first and/or second condenser may form a first and/or second condenser section.

The second condenser may be at least one of a water plate condenser, a plate condenser, a multiport extruded tube condenser, finned tubes condensers, a plate and bar condenser, a cold plate, and at least one roll-bonded panel.

According to another aspect of the invention, the first condenser is attached to the second evaporator forming a heat exchanger such that the second interface in form of a first thermoconducting backside of the first condenser is thermally connected to the third interface in form of a second thermoconducting backside of the second evaporator.

If it is desired to improve the efficiency of manufacturing the heat exchanger system, this object may be achieved by providing such a heat exchanger, as the first condenser and second evaporator may be thermally connected to each other in a standardized way at a location other than the location of final assembly such that time may be saved.

According to another aspect of the invention, the second evaporator has the same design as the first condenser such that a simple and efficient production of the heat exchanger system may be enabled which may be a desired object of the invention.

The second evaporator may be a condenser working as an evaporator in an operating state of the heat exchanger system, wherein the first condenser and the second evaporator may be attached to each other by a fixing device such that the second interface is thermally connected to the third interface the heat exchanger is formed.

The fixing device may be a bolt or screw and nut combination or at least one screw screwed in corresponding threaded first and second recesses of the first condenser and the second evaporator, or at least one clamping device, or an adhesive.

According to another aspect of the invention, the first cooling circuit of the heat exchanger system comprises a first manifold fluidly connected to at least one first evaporator conduit of the first evaporator for collecting at least partially vaporized first coolant from the first evaporator in an operating state of the heat exchanger system, said first manifold being fluidly connected to at least one first condenser conduit of the first condenser for feeding the at least partially vaporized first coolant to the first condenser in an operating state of the heat exchanger system. The first cooling circuit further comprises a second manifold fluidly connected to the at least one first condenser conduit for collecting condensed first coolant from the first condenser in an operating state of the heat exchanger system, said second manifold being fluidly connected to the at least one first evaporator conduit for feeding the condensed first coolant back to the first evaporator in an operating state of the heat exchanger system. The first manifold is arranged above the second manifold such that in an operating state of the heat exchanger system the condensed first coolant is enabled to move by gravity through the at least one first condenser conduit to the second manifold. The second cooling circuit may comprise the same components and features as the components and features described above for the first cooling circuit. The term fluidly connected may also incorporate the meaning of fluidly and mechanically connected or may incorporate the meaning of fluidly, mechanically and thermally connected.

If it is desired to improve the efficiency and error-proneness of a cooling device or a heat removal device, this object may be achieved by providing such a heat exchanger system with a gravity-driven movement of the condensed first coolant as pumps to drive the coolant may be omitted.

The at least one first condenser conduit may comprise at least one first channel extending traverse from a first condenser plate for guiding a vaporous part of at least partially vaporized first coolant from a bottom part of the first condenser conduit to a top part of the first condenser conduit above the bottom part in an operating state of the first cooling circuit. At least one second channel of the first condenser conduit is arranged at least partially embedded in a first condenser plate of the first condenser for guiding a liquid part of at least partially vaporized coolant from the top of the first condenser conduit to the bottom of the first condenser conduit in an operating state of the first cooling circuit.

Such a separation of the second conduit and at least one first and second channel may enable a separation of the vaporous part from a liquid part of the at least partially vaporized first coolant if this object is desired to be achieved. An at least one second condenser conduit may comprise at least one first and second channel as described above for the at least one first condenser conduit.

According to another aspect of the invention, the heat exchanger system further comprises a first vapour conduit for guiding at least partially vaporized first coolant from the first evaporator to the first condenser, and a first condensate conduit for guiding condensed first coolant from the first condenser to the first evaporator. The first vapour conduit and the first condensate conduit may be at least partially led coaxially to one another in between the first evaporator and the first condenser. The second cooling circuit may comprise the same components and features such as a second vapour conduit and a second condensate conduit as the components and features described above for the first cooling circuit.

If a more compact and more efficient heat exchanger system is desired, this object may be achieved by such a heat exchanger system with a coaxial arrangement of the first vapour conduit and the first condensate conduit.

The connection of the first or second vapour conduit to the first or second condenser may be provided by a plastic or a metallic hose, wherein the hose may be flexible or non-flexible. If a flexible hose is used this may enhance the flexibility of installing the heat transfer system to a unit incorporating the heat source such as a cabinet, for example.

A heat transfer component thermally connected and arranged in between the second interface and the third interface may be provided, said heat transfer component for at least partially transferring heat from the second interface to the third interface in an operating state of the heat exchanger system.

The heat transfer component may be a thermal paste, and may enhance the thermal conductivity between the second and third interfaces and thus the efficiency of the heat exchanger system, if this is desired.

According to another aspect of the invention, the first coolant in the first cooling circuit has a first filling ratio, and the second coolant in the second cooling circuit has a second filling ratio which is different from the first filling ratio. First and second coolants may be put at comparable or similar pressure conditions or at different pressure conditions in the first and second cooling circuits.

If an efficient performance of the heat exchanger system is desired, this object may be achieved by providing such a heat exchanger system with different first and second filling ratios of the first and second coolants.

According to another aspect of the invention, the first coolant and the second coolant are structurally identical. By the term structurally identical, an identical form of the material constitution is understood, for example concerning the chemistry, that may comprise at least one of ammonia, water, an HFC fluid or HFC fluids such as tetrafluorethane (R134a) and pentafluorpropane (R245fa), or a mixture thereof, depending on the requirements and the particular purpose of the heat exchanger system.

If a simple and efficient coolant exchange and maintenance as well as performance of the heat exchanger system are desired, this object may be achieved by providing such a heat exchanger system with structurally identical first and second coolants.

In an operating state of the heat exchanger system, the second cooling circuit may be at a lower saturation temperature than the first cooling circuit according to any one of the above and below mentioned embodiments and aspects of the invention.

According to another aspect of the invention, the second interface and the third interface are planar.

By providing a planar second and third interface, mounting the third interface to the second interface may be optimized with respect to the mounting time and the thermal conductive fitting of the second and third interfaces, if this is desired.

According to an embodiment of the invention, a switching module is provided having a heat source with at least one of an electric and an electronic component. The switching module comprises a first cooling circuit that is formed as a loop-type thermosiphon comprising a first coolant which at least partially changes phases between a liquid state and a vaporous state in an operating state of the first cooling circuit when heated up above a vaporization point of the first coolant. The first cooling circuit has a first interface for receiving a thermal load from the heat source that is thermally connectable to the first interface, and has a second interface for releasing a major portion of said thermal load. The first interface acts as a first evaporator and the second interface acts as a first condenser in an operating state of the first cooling circuit.

If an efficient and simple cooling of a switching module or heat removal from a switching module in an operating state of the switching module is desired, this may be achieved by providing such a switching module with the first cooling circuit, as pumps to move the first coolant are not required.

The switching module may also relate to converter modules, such as modules that are not on and off but amend at least one of the current rate, the voltage rate, the current and voltage kind (AC-DC or DC-AC or alternating DC) and an AC amplitude or cycle. The switching modules may comprise an enclosure and may be installed in a switching cabinet with a housing.

According to another aspect of the invention, the switching module comprises at least one circuit breaker having a plurality of electric and/or electronic components with different electric phases. The first interface is thermally connected to a thermoconductive electric insulator that is thermally connected to the plurality of electric and/or electronic components or to a plurality of thermoconductive electric insulators, each of which is thermally connected to one of the plurality of electric and/or electronic components.

If a reliable and efficient heat removal from a switching module is desired, this may be achieved by such a switching module with at least one thermoconductive electric insulator which may prevent short circuits between different phases.

According to an embodiment of the invention, a switching cabinet is provided that comprises a heat exchanger system of any one of the preceding and following embodiments and aspects of the invention, and at least one switching module according to the preceding and following embodiments or aspects of the invention. The second cooling circuit is thermally connected to the first cooling circuit, and the major portion of the thermal load generateable by the heat source is releasable at the fourth interface in an operating state of the heat exchanger system. In other words, the major portion of the thermal load that may be generated by the heat source is releasable at the fourth interface in an operating state of the heat exchanger system.

If a flexible and efficient heat removal from a switching cabinet and switching modules arranged therein is desired, this object may be achieved by providing such a switching cabinet with the heat exchanger system comprising the first cooling circuit at the switching modules and the thereto thermally connected second cooling circuit with the second condenser or fourth interface for releasing the thermal load generated by the switching module in an operating state, which second condenser being located at a suitable location for releasing said thermal load from the switching module and the switching cabinet.

According to another aspect of the invention, the switching cabinet comprises a housing, wherein the fourth interface forming the second condenser is arranged in a peripheral area of the housing or outside the housing with respect to an interior of the switching cabinet that is confined by the housing.

If an improved and more efficient heat removal from the switching module and the switching cabinet is desired, this object may be achieved by such a switching cabinet comprising the heat exchanger system with the second condenser arranged in a peripheral area of the housing of the switching cabinet outside the cabinet.

According to an embodiment of the invention, a method of manufacturing a heat exchanger system according to any one of the preceding and following embodiments or aspects of the invention is provided, comprising the steps of: thermally connecting the first interface to at least one of an electric and electronic component of the heat source, thermally connecting the first interface to the second interface of the first cooling circuit, thermally connecting the second interface to the third interface of the second cooling circuit, thermally connecting the third interface to the fourth interface of the second cooling circuit, filling a first coolant in the first cooling circuit, and filling a second coolant in the second cooling circuit.

If an efficient production of a heat exchanger system is desired, this may be achieved by the method of manufacturing the heat exchanger system mentioned above.

The method may further comprise the steps of fluidly connecting the first evaporator conduit with the first condenser conduit forming the first cooling circuit, and the step of fluidly connecting the second evaporator conduit with the second condenser conduit forming the second cooling circuit.

The method may further comprise the step of thermally connecting a heat transfer component to the second interface and to the third interface in between the second and third interface such that heat is transferred from the second interface to the third interface in an operating state of the heat exchanger system.

According to an embodiment of the invention, the use of the heat exchanger system according to anyone of the preceding and following embodiments and aspects of the invention is provided for transferring at least a portion of a thermal load from at least one electric and/or electronic component being thermally connected to the first interface to a second condenser in an operating state of the heat exchanger system, said second condenser being arranged spatially distanced to the first interface.

By arranging the second condenser spatially distanced to the first interface removal of the thermal load from the at least one electric and/or electronic component may be enhanced and efficient.

These and other aspects of the present invention will become apparent from and elucidated with reference to the embodiments described hereinafter.

### BRIEF DESCRIPTION OF THE DRAWINGS

The subject matter of the invention will be explained in more detail in the following text with reference to exemplary embodiments which are illustrated in the attached drawings.
Fig. 1 schematically shows a view of a heat exchanger system for removing heat from a heat source of a switching module inside a switching cabinet according to an embodiment of the invention.
Fig. 2 schematically shows view of another heat exchanger system for removing heat from a heat source of a switching module inside a switching cabinet according to an embodiment of the invention.
Fig. 3 schematically shows a view of another heat exchanger system for removing heat from a heat source of a switching module inside a switching cabinet according to an embodiment of the invention.
Fig. 4 schematically shows an enlarged perspective view of the heat exchanger system of Fig. 3 without the switching cabinet according to an embodiment of the invention.
Fig. 5 schematically shows an enlarged perspective view of the heat exchanger system of Fig. 3 according to an exemplary embodiment of the invention.
Fig. 6 schematically shows an enlarged perspective view of the heat source with a first cooling circuit of the heat exchanger system of Fig. 5 according to an exemplary embodiment of the invention.
Fig. 7 schematically shows a perspective view of the first condenser of the first cooling circuit of Fig. 6 according to an exemplary embodiment of the invention.
Fig. 8 schematically shows a perspective view of the second evaporator of the second cooling circuit of the heat exchange system according to Fig. 5 according to an exemplary embodiment of the invention.
Fig. 9 schematically shows a perspective view of the second evaporator of Fig. 8 with a transversal section view of the upper manifold according to an exemplary embodiment of the invention.
Fig. 10 schematically shows a perspective view of the second evaporator of Fig. 8 with a longitudinal section view of the manifolds according to an exemplary embodiment of the invention.
Fig. 11 schematically shows a perspective sectional view of the second evaporator of Fig. 8 and an enlarged part thereof according to an exemplary embodiment of the invention.
Fig. 12 schematically shows a perspective view of a heat exchanger comprising the first condenser of Fig. 7 and the second evaporator of Fig. 8 according to an exemplary embodiment of the invention.
Fig. 13 schematically shows a perspective view of part of the second condenser of the heat exchanger system of Fig. 4 in form of one finned tube heat exchanger according to an exemplary embodiment of the invention.
Fig. 14 schematically shows a perspective view of a second condenser with partially coaxial led second vapour conduit and second condensate conduit according to an exemplary embodiment of the invention.
Fig. 15 schematically shows a perspective view of a roll-bonded heat exchanger forming the second condenser according to an exemplary embodiment of the invention.
Fig. 16 schematically shows a perspective view of a cold plate of the first condenser of the heat exchanger system according to an exemplary embodiment of the invention.
Fig. 17 schematically shows a perspective cross sectional view of the heat exchanger cold plate of Fig. 16 according to an exemplary embodiment of the invention.
Fig. 18 schematically shows a heat exchanger comprising a first condenser in form of a cold plate of Fig. 16 and a second evaporator in form of a panel of Fig. 16 thermally connected to each other according to an exemplary embodiment of the invention.
Fig. 19 schematically shows a flow chart of a method of manufacturing a heat exchanger system according to an exemplary embodiment of the invention.

The reference signs used in the drawings and their meanings are listed in summary form as a list of reference signals. In principal, identical parts are provided with the same reference symbols than the figures.

### DETAILED DESCRIPTION OF PREFERRED EMBODIMENTS

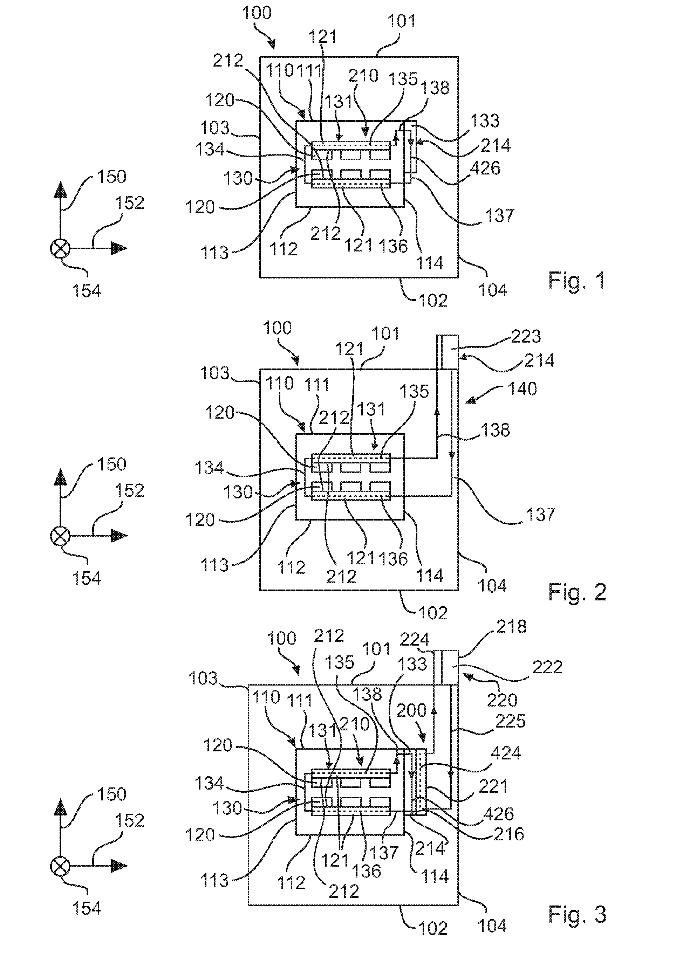

Fig. 1 schematically shows a view of a switching cabinet 100 with a housing having a housing top side 101 and a housing bottom side 102 defined by a horizontal direction 152 and a longitudinal direction 154, and having a housing left side 103 and a housing right side 104 defined by a vertical direction 150 and the longitudinal direction 154. Inside the switching cabinet 100 there is arranged a switching module 110 having an enclosure with an enclosure top side 111 and an enclosure bottom side 112 defined by the horizontal direction 152 and the longitudinal direction 154, and having an enclosure left side 113 and an enclosure right side 114 defined by the vertical direction 150 and the longitudinal direction 154. Six electric or electronic components 120 of the switching module 110 extend in the longitudinal direction 154 and are part of a heat source 130. A heat exchanger system having a first cooling circuit 210 is provided for removing heat from the heat source 130.

The first cooling circuit 210 is formed as a loop-type thermosiphon comprising a first coolant which at least partially changes phases between a liquid state and a vaporous state in an operating state of the first cooling circuit 210 when heated up above a vaporization point of the first coolant. The first cooling circuit 210 has a first interface 212 for receiving a thermal load from the heat source 130 that is thermally connectable to the first interface 212. The first cooling circuit 210 has a second interface 214 for releasing a major portion of said thermal load or all of said thermal load. In an operating state of the first cooling circuit 210, the first interface 212 acts as a first evaporator 131 which comprises two first evaporator conduits 135, 136, a lower first evaporator conduit 136, an upper first evaporator conduit 135, and a connecting adiabatic conduit 134 connecting conduits 135 and 136. The second interface 214 acts as a first condenser 133 in an operating state of the first cooling circuit 210.

Thermoconductive electric insulators 121 extend in the horizontal direction 152 and are adapted to electrically insulate the electric and/or electronic components 120 from the first evaporator 131. The insulators 121 are thermally connected to the plurality of electric and electronic components 120 which may have different electrical phases. The switching module 110 may comprise at least one circuit breaker having the plurality of electric and/or electronic components 120 with different electrical phases. The first interface 212 is thermally connected to the plurality of thermoconductive electric insulator 121 each of which is thermally connected to one of the plurality of electric and/or electronic components 120. In Fig. 1 six thermoconductive electric insulators 121 and six electric and/or electronic components 120 are shown.

The first coolant is at least partially evaporated at the lower first evaporator conduit 136 and at the upper first evaporator conduit 135, and is led through the first vapour conduit 138 from the first evaporator 131 to the first condenser 133. Condensed first coolant is guided from the first condenser 133 to the first evaporator 131 by a first condensate conduit 137. The first vapour conduit 138 and the first condensate conduit 137 may at least partially be led coaxially to one another in between the first evaporator 131 and the first condenser 133. The condensed coolant may move in a first condenser conduit 426 towards the first condensate conduit 137.

The first condenser 133 is arranged at the enclosure right side 114 of the switching module 110 which may be a circuit breaker. However, the first condenser 133 may be arranged anywhere at a spatial distance from the heat source 130.

Fig. 2 schematically shows a view of the switching cabinet 100 with a switching module 110 and a heat exchange system of Fig. 1, with the difference, that a condenser 223 is arranged outside of the switching cabinet 100 at the housing top side 101 of the housing. The cooling circuit is an outer cooling circuit 140 comprising a different arrangement of the condenser 223 compared to the first evaporator 131 of the first cooling circuit 210 of Fig. 1 resulting in a removal of heat from the heat source 130 to the ambient of the switching cabinet 100.

Fig. 3 schematically shows a view of the switching cabinet 100 and the switching module 110 with a heat exchanger system 200 for removing heat from a heat source 130 comprising at least one of an electric and electronic component 120, the heat exchanger system 200 having a first cooling circuit 210 according to Fig. 1. The first cooling circuit 210 is formed as a loop-type thermosiphon comprising a first coolant with at least partly changes phases between a liquid state and a vaporous state in an operating state of the first cooling circuit 210 when heated up above a vaporization point of the first coolant. The first interface 212 acts as a first evaporator 131, and the second interface 214 acts as a first condenser 133 in an operating state of the first cooling circuit 210.

The heat exchanging system 200 further comprises a second cooling circuit 220 that is formed as a loop-type thermosiphon comprising a second coolant which at least partially changes phases between a liquid state and a vaporous state in an operating state of the cooling circuit 220 when heated up above a vaporization point of the second coolant. The second cooling circuit 220 has a third interface 216 that is thermally connected to the second interface 214. The second cooling circuit 220 has a fourth interface 218 for releasing the major portion said thermal load taken up at the third interface 216. The third interface 216 acts as a second evaporator 221 and the fourth interface 218 acts as a second condenser 222 in an operating state of the second cooling circuit 220. The first coolant and the second remain separated from one another in an operating state of the heat exchange system.

The third interface 216 may be detachably mounted to the second interface 214 to enable an effective and simple exchange for example of the switching modules with the first cooling circuit or an exchange of the second cooling circuit.

The connection of a second vapor conduit 224 towards the second condenser 222 at the top of the cabinet is provided by a metallic or plastic hose. The hose can have different nature such that it can be flexible or not flexible. The flexibility option enables a corresponding flexibility in the installation of the device which leaves a major degree of freedom to the cabinet designers. A flexible hose allows different layouts according to the customer requirements, starting from the same design. A second condensate conduit 225 leads the condensate back from the second condenser 222 to the second evaporator 221 wherein the second coolant is at least partially vaporized in the second evaporator conduits 424.

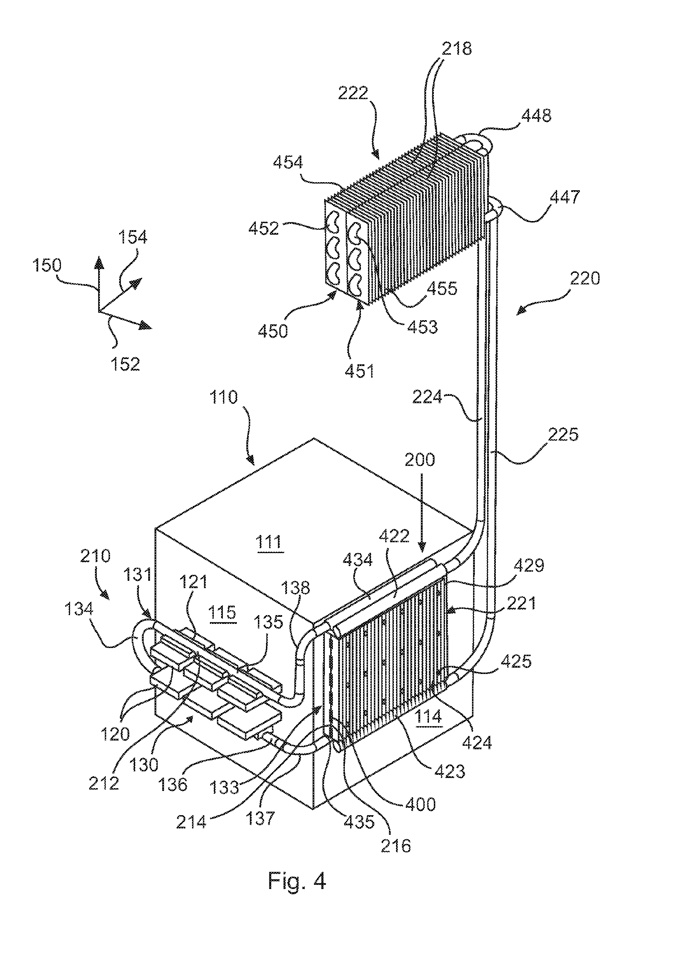

Fig. 4 schematically shows an enlarged perspective view of the heat exchange system 200 and the switching module 110 according to Fig. 3. The first interface 212 is thermally connected to an insulator 121 and is thermally connected to the plurality of electric and/or electronic components 120 or to a plurality of insulators 121 each of which is thermally connected to one of the plurality of electric and/or electronic components 120. The second interface 214 and the third interface 216 are planar but may have a different shape than the planar shape suitable for heat exchange according to further exemplary embodiments of the invention. The first coolant and the second coolant may be structurally identical concerning the material constitution such as a chemistry which may comprise at least one of ammonia, water, a HFC fluid of HFC fluids such as tetrafluorethane (R134a) and pentafluorpropane (R245fa), or a mixture thereof, depending on the requirements and the particular purpose of the heat exchange system 200.

The first coolant in the first cooling circuit 210 may have a first filling ratio, and the second coolant in the second cooling circuit 220 may have a second filling ratio which is different from the first filling ratio, wherein at the time of putting the first and second coolants into the first and second cooling circuits 210, 220, the coolants have comparable pressure conditions but may also have different pressure conditions. In an operating state of heat exchange system 200 the second cooling circuit 220 may be at a lower saturation temperature than the first cooling circuit 210. The first and second evaporators may be understood as a first and second evaporator section, wherein the first and second condenser may be understood as a first and second condenser section.

Second condenser 222 comprises a first finned tubes heat exchanger 450 and a second finned tube heat exchanger 451 with first and second finned tubes 452, 453 acting as second condenser conduits, and with first and second fins 454, 455. An at least partially vaporized second coolant is guided from the second evaporator 221 to both, the first and second finned tube heat exchangers 450, and 451, and the first and second finned tubes 452, 453 via the second vapour conduit 224 and a fifth manifold 448 for collecting the at least partially vaporized second coolant. Heat is dissipated by the fourth interface 218 at first and second fins 454, 455 such that the partially vaporized second coolant is condensed in the finned tubes 452, 453 and guided via a sixth manifold 447 for collecting the condensed second coolant to the second condensate conduit 225, which guides the condensed second coolant from the second condenser 222 to the second evaporator 221.

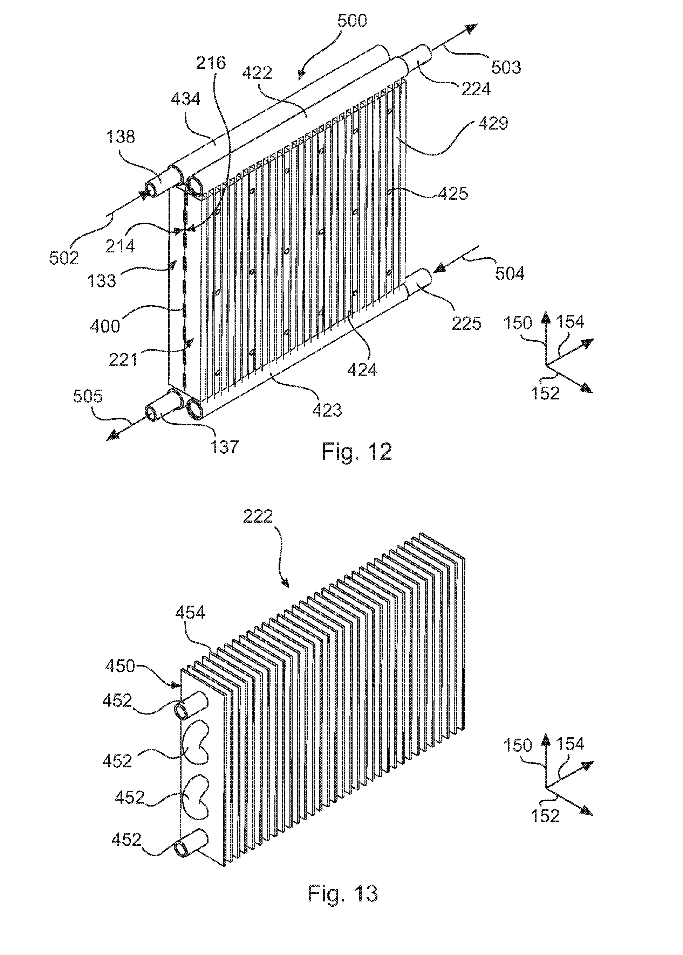

The first condenser 133 and the second evaporator 221 are attached to one another forming a heat exchanger 500 (see also Fig. 12) such that the second interface 214 in form of a first thermoconducting back side of the first condenser 133 is thermally connected to the third interface 216 in form of a second thermoconducting back side of the second evaporator 221. A heat transfer component 400 may be thermally connected to and arranged in between the second interface 214 and the third interface 216 for at least partially transferring heat from the second interface 214 to the third interface 216 in an operating state of the heat exchange system 200. The heat transfer component 400 may be a thermal paste that might be applied either to the second interface 214, to the third interface 216, or to the second interface 214 and the third interface 216.

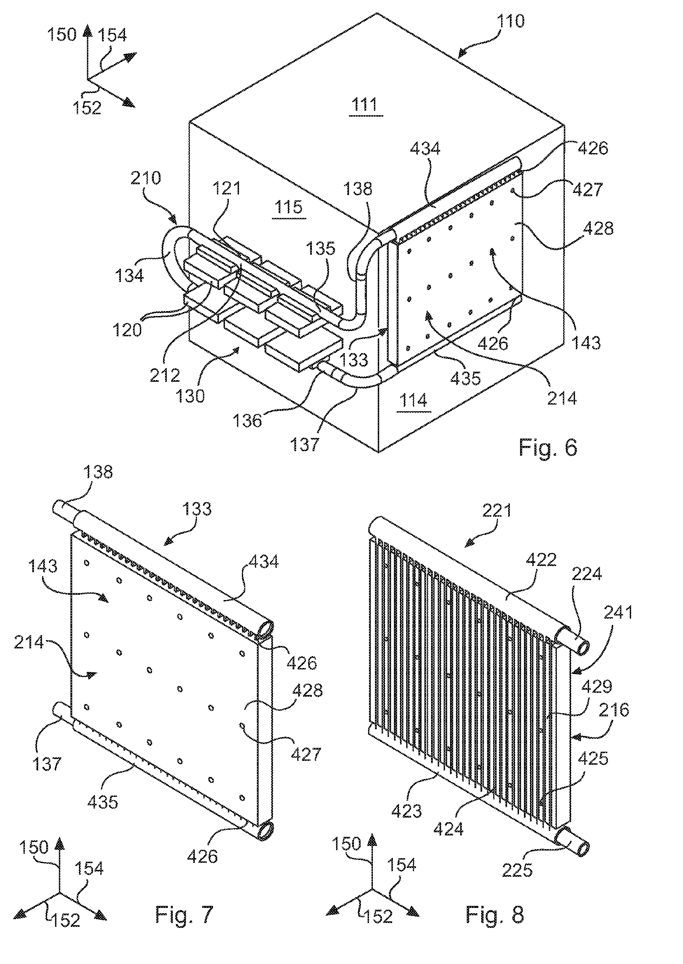

The first cooling circuit 210 comprises a first manifold 434 fluently connected to at least one first evaporator conduit 134, 135, 136 of the first evaporator 131 for collecting at least partially vaporized first coolant from the first evaporator 131 in an operating state of the thermosyphon cooling system 200. Said first manifold 434 is fluently connected to at least one first condenser conduit 426, not shown (see Fig. 7), of the first condenser 133 for feeding the at least partially vaporized first coolant to the first condenser 133 in an operating state of the heat exchange system 200.

A second manifold 435 is fluently connected to the at least one first condenser conduit 426 (see Fig. 7) for collecting condensed first coolant from the first condenser 133 in an operating state of the heat exchanger system 200. Said second manifold 435 is fluently connected to the at least one first evaporator conduit 134, 135, 136 for feeding the condensed first coolant back to the first evaporator 131 in an operating state of the heat exchanger system 200. The first manifold 434 is arranged above the second manifold 435 such that in an operating state of the heat exchanger system 200 the condensed first coolant is enabled to move by gravity through the at least one first condenser unit 426 to the second manifold 435.

The second cooling circuit 220 comprises the fifth manifold 448 fluently connected to at least one second evaporator conduit 424 of the second evaporator 221 for collecting at least partially vaporized second coolant from the second evaporator 221 in an operating state of the heat exchanger system 200. Said fifth manifold 448 is fluently connected to at least one second condenser conduit 452, 453 of the second condenser 222 for feeding the at least partially vaporized second coolant to the second condenser 222 in an operating state of the heat exchanger system 200. A sixth manifold 447 is fluently connected to the at least one second condenser conduit 452, 453 for collecting condensed second coolant from the second condenser 222 in an operating state of the heat exchanger system 200. Said sixth manifold 447 is fluently connected to the at least one second evaporator conduit 424 for feeding the condensed second coolant back to the second evaporator 221 in an operating state of the heat exchanger system 200. The fifth manifold 448 is arranged above the sixth manifold 447 such that in an operating state of the heat exchanger system 200 the condensed second coolant is enabled to move by gravity through the at least one second condenser circuit 452, 453 of the second condenser 222 to the sixth manifold 447. The arrangement of the fifth and sixth manifold 448, 447 is optional and may be also designed in different ways suitable for a movement of the second coolant by gravity.

The second evaporator 221 has a second evaporator plate 429, wherein second evaporator mounting holes 425 are arranged for fixing the second evaporator 221 to the first condenser 133 by screws, for example. A third manifold 422 is fluidly connected to the at least one second evaporator conduit 242 and to the second vapour conduit 224 for collecting at least partially vaporized second coolant from the second evaporator conduit 242 and guiding the collected second coolant to the second vapour conduit 224 in an operating state of the heat exchanger system 200. A fourth manifold 423 is fluidly connected to the at least one second evaporator conduit 242 and the second condensate conduit 225 for collecting the condensed second coolant from the second condensate conduit 225 and for feeding the second coolant to the at least one second evaporator conduit 242 in an operating state of the heat exchanger system 200.

The third interface 216 may be detachable from the second interface 214 and the second evaporator 221 may have the same design as the first condenser 133.

The enclosure of the switching module 110 which may be a circuit breaker comprises an enclosure front side 115 defined by the horizontal direction 152 and the vertical direction 150, from which enclosure front side 115 the electric or electronic components 120 are extending in the longitudinal direction 154. The enclosure further comprises an enclosure right side 114 defined by the longitudinal direction 154 and the vertical direction 150, at which the first condenser 133 is mounted.

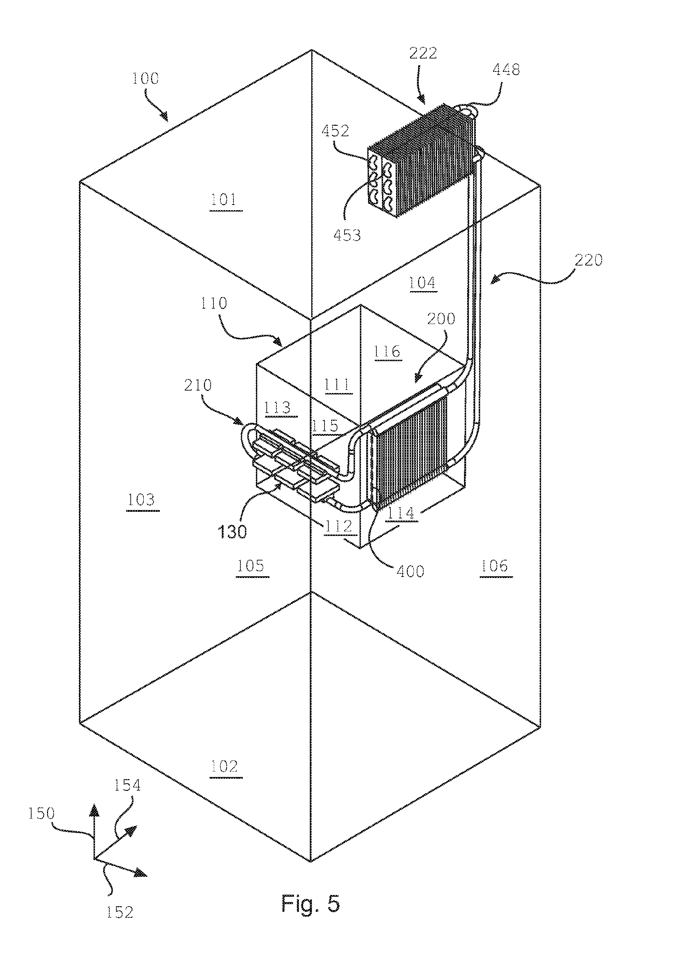

Fig. 5 schematically shows a perspective view of the switching module 110 with a heat exchanger system 200 of Fig. 4 with a switching cabinet 100, in which the switching module 112 is installed or arranged, and outside of which at a housing top side 101 of the housing the second condenser 222 is installed. The housing top side 101 is defined by the horizontal direction 152 and the longitudinal direction 154. The housing bottom side 102 is also defined by the horizontal direction 152 and the longitudinal direction 154 and is arranged below the top side 101. A housing front side 105 is defined by the vertical direction 150 and the horizontal direction 152 as well as a housing back side 106 which is arranged opposite to the housing front side 105. A housing right side 104 is defined by the vertical direction 150 and the longitudinal direction 154 as well as a housing left side 103 which is arranged opposite to the housing right side 104 of the housing. The switching module enclosure comprises a respective enclosure front side 115, an enclosure back side 116, an enclosure top side 111, an enclosure bottom side 112, an enclosure right side 114 and an enclosure left side 113.

The switching cabinet 100 comprises a heat exchanger system 200 wherein the second cooling circuit 220 is thermally connected to the first cooling circuit 210 and wherein the major portion of the thermal load generateable, i.e. producible by the heat source 130 is releasable at the fourth interface 218 in an operating state of the heat exchanger system 200. In other words, the major portion of the thermal load that may be generated by the heat source 130 is releasable at the fourth interface 218 in an operating state of the heat exchanger system 200. The switching cabinet 100 comprises a housing 101, 102, 103, 104, 106, wherein the fourth interface 218 forming the second condenser 222 is arranged in a peripheral area of the housing or outside the housing 101, 102, 103, 104, 106 with respect to an interior of the switching cabinet 100 that is confined by the housing 101, 102, 103, 104, 106.

Fig. 6 schematically shows a perspective view of the switching module 110 and the first cooling circuit 210 of the heat exchanger system 200 according to Fig. 5. The first condenser 133 comprises a first condenser plate 428 acting as the second interface 214 with a first thermoconducting back side 143, and first condenser mounting holes 427 for mounting the first condenser 133 to the second evaporator and/or to a structure at a desired location such as the enclosure right side 114.

The switching module 110 may comprise at least one circuit breaker having a plurality of electric and/or electronic components 120 with different electrical phases. The first interface 212 is thermally connected to a thermoconductive electric insulator 121 that is thermally connected to the plurality of electric and/or electronic components 120 or to a plurality of thermoconductive insulators 121 each of which is thermally connected to one of the plurality of electric and/or electronic components 120.

Fig. 7 schematically shows an enlarged perspective view of the first condenser 133 according to Fig. 6.

Fig. 8 schematically shows an enlarged perspective view of the second evaporator 221 according to Fig. 4 acting as the third interface 216 with a second thermo conducting back side 241 and a second evaporator plate 429, wherein the second evaporator conduits 424 are embedded, and with second evaporator mounting holes 425.

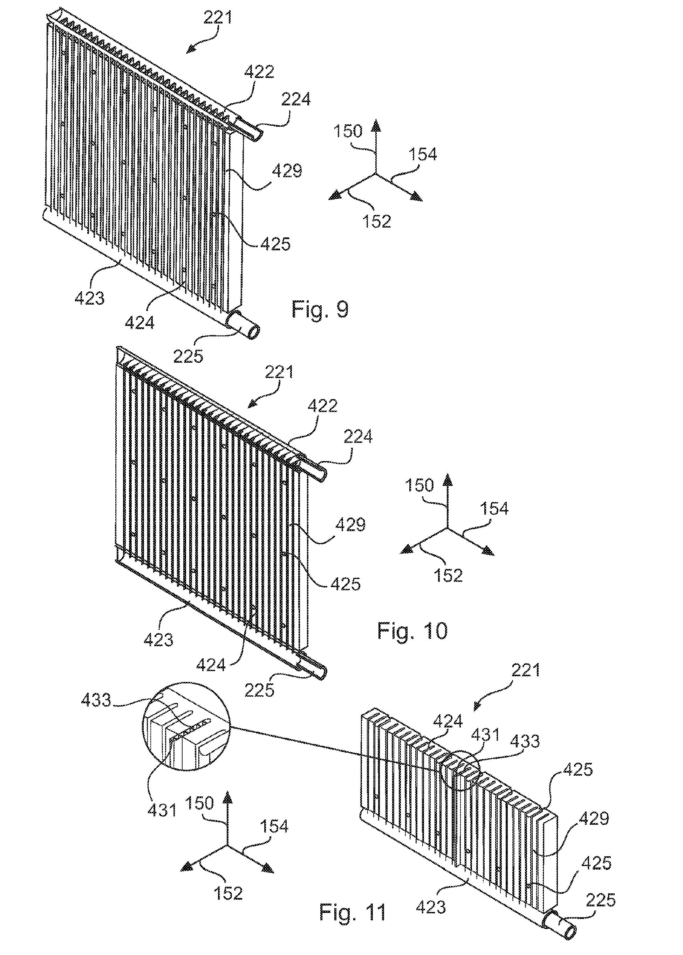

Fig. 9 schematically shows a perspective view of the second evaporator 221 of fig. 9 with a transversal section of the third manifold 422, showing that a plurality of second evaporator conduits 424 partially extend in the third manifold 422 in the vertical direction 150.

Fig. 10 schematically shows a perspective view of the second evaporator 221 of Fig. 8 with a longitudinal section of the third manifold 422 and the fourth manifold 423, showing the plurality of second evaporator conduits 424 also partially extending in the fourth manifold 423 in the vertical direction 150.

Fig. 11 schematically shows a perspective sectional view of the second evaporator 221 of Fig. 8 with an enlarged part of a second evaporator conduit 424. The second evaporator conduit 424 of the second evaporator 221 comprises at least one first channel 431 arranged outside and extending in a horizontal direction 152 traverse to the second evaporator plate 429 for guiding a vaporous part of at least partially vaporized second coolant from a bottom part of the second evaporator conduit 424 to a top part of the second evaporator conduit 424 above the bottom part of the second evaporator conduit 424.

Five second channels 433 are arranged at least partially embedded in the second evaporator plate 429 such that the second channels 433 are embedded in the second evaporator plate 429 in the horizontal direction 152 for guiding a liquid part of at least partially vaporized second coolant from the top part of the second evaporator conduit 424 to the bottom part of the second evaporator conduit 424.

Such a separation of the second evaporator conduit 424 and at least one first and second channel 431, 433 may enable a separation of a vaporous part from a liquid part of the at least partially vaporized second coolant.

The above mentioned design of the second evaporator 221 may be also implemented for the first evaporator 131, which may be an evaporator of any type according to exemplary embodiments of the invention.

Fig. 12 schematically shows a heat exchanger 500 formed by the first condenser 133 being attached to the second evaporator 221 such that the second interface 214 in form of a first thermconducting backside 143 of the first condenser 133 is thermally connected to the third interface 216 in form of a second thermoconducting back side 241 of the second evaporator 221. An at least partially vaporized first coolant 502 is moving into the first manifold 434 condensed by the first condenser 133 and the condensed first coolant 505 is collected and guided to the first condensate conduit 137.

The condensed second coolant 504 moves to the fourth manifold 423 and from there to the second evaporator 221 up to the third manifold 422 as at least partially vaporized second coolant 503, which leaves the third manifold 422 in a direction towards the second condenser.

Fig. 13 schematically shows a perspective view of a second condenser 222 in form of the first finned tube heat exchanger 450 as shown in Fig. 5.

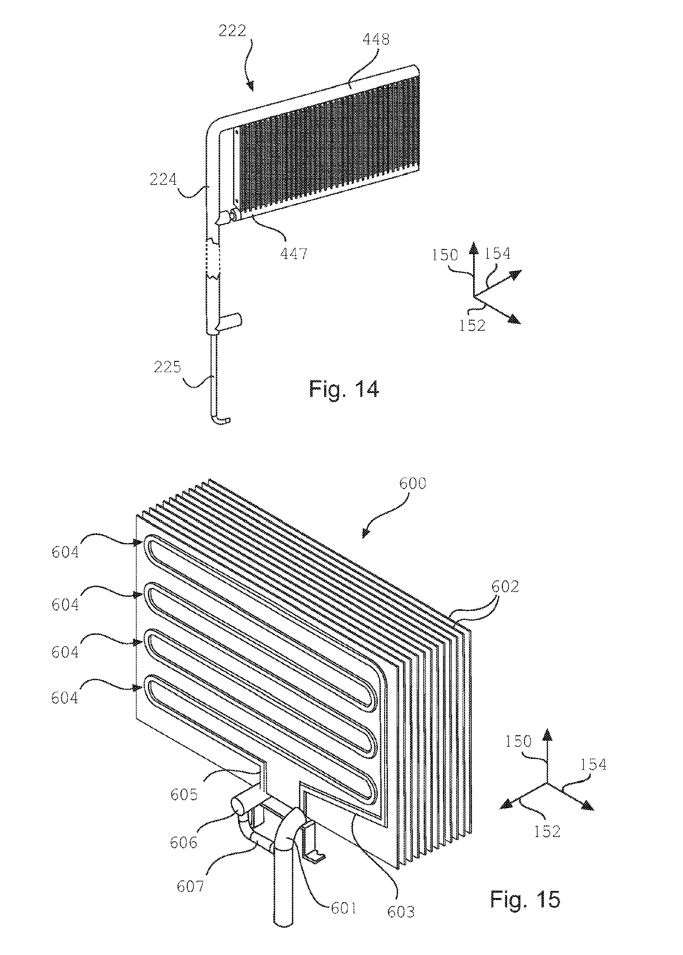

Fig. 14 schematically shows a perspective view of part of a second condenser 222 with a fifth manifold 448 for collecting at least partially vaporized second coolant and a six manifold 447 for collecting condensed second coolant. A second vapour conduit 224 is provided for guiding at least partially vaporized second coolant from the second evaporator to the second condenser 222. A second condensate conduit 225 is provided for guiding condensed second coolant from the second condenser 222 to the second evaporator, wherein the second vapour conduit 224 and the second condensate conduit 225 are at least partially led coaxially to one another in between the second evaporator and the second condenser 222.

Fig. 15 schematically shows a second condenser in form of a roll bond panel heat exchanger 600 with a plurality of roll band panels 602 each comprising a roll bond conduit 603, 604, 605 with a plurality of roll bond channels 604 and a vapour channel portion 603 and a condensate conduit portion 605. Via the condensate conduit portion 605 the condensed second coolant is moving by gravity to the roll bond collector 606 and from there via a roll bond condensate pipe 607 to the second evaporator. At least partially vaporized second coolant moves via roll bond vapour conduit 601 and vapour conduit portion 603 in the conduit of each roll bond panel 602.

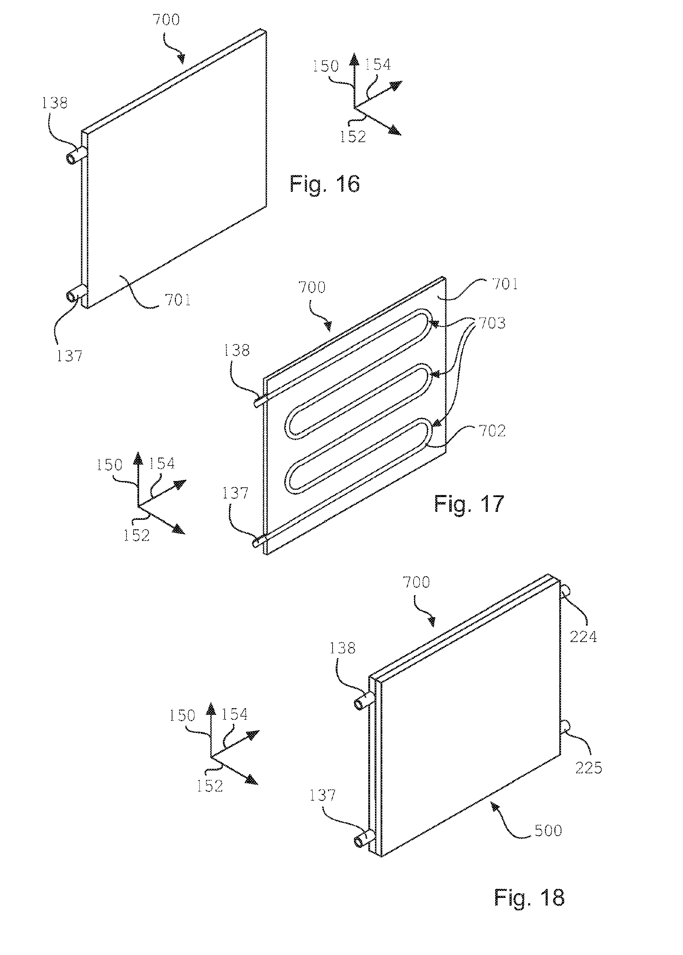

Fig. 16 schematically shows a perspective view of a first condenser in form of a cold plate 700 which comprises a cold plate conduit 702 with a plurality of cold plate channels 703 wherein a at least partially vaporized first coolant passes via the first vapour conduit 138 into the cold plate conduit 702 and leaves the cold plate conduit 702 as condensed first coolant via the first condensate conduit 137 as shown in Fig. 17. The cold plate 700 comprises a cold plate thermoconducting back side 701.

Fig. 17 schematically shows a perspective cross sectional view of the cold plate 700 of Fig. 16, wherein the cold plate conduit 702 is visible.

Fig. 18 schematically shows a heat exchanger 500 consisting of two identical cold plates 700 attached to each other, one cold plate forming the first condenser and the other cold plate forming the second evaporator, such that the second interface in form of the cold plate thermoconducting back side 701 of the first condenser is thermally connected to the third interface in form of a cold plate thermoconducting back side 701 of the second evaporator.

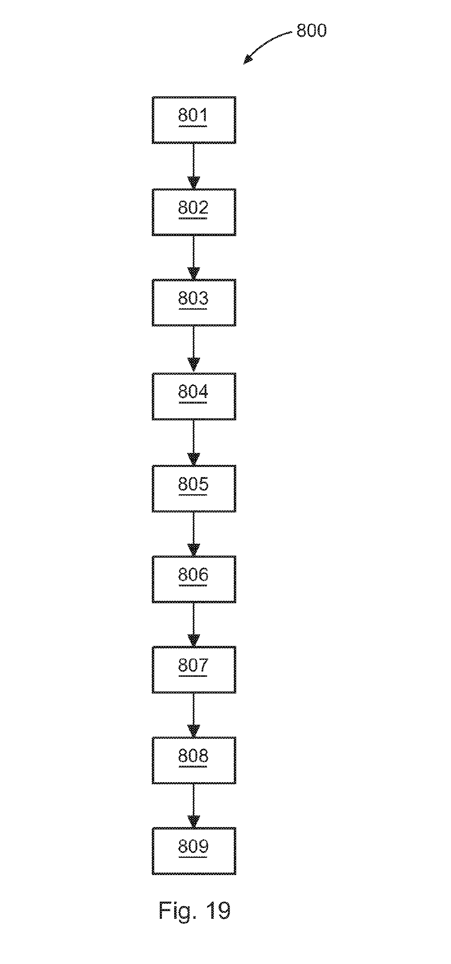

Fig. 19 schematically shows a flow chart of a method 800 of manufacturing a heat exchanger system according to the mentioned exemplary embodiments and aspects of the invention, comprising the steps of: thermally connecting 801 the first interface to at least one electric and/or electronic component of the heat source, thermally connecting 802 the first interface to the second interface of the first cooling circuit, thermally connecting 803 the second interface to the third interface of the second cooling circuit, thermally connecting 804 the third interface to the fourth interface of the second cooling circuit, filling 805 a first coolant in the first cooling circuit, and filling 806 a second coolant in the second cooling circuit.

The method may further comprise the steps of fluidly connecting 807 the first evaporator conduit with the first condenser conduit forming the first cooling circuit, and the step of fluidly connecting 808 the second evaporator conduit with the second condenser conduit forming the second cooling circuit.

The method may further comprise the step of thermally connecting 809 a heat transfer component to the second interface and to the third interface in between the second and third interface such that heat is transferred from the second interface to the third interface in an operating state of the heat exchanger system. The steps of the method mentioned above do not represent a defined sequence or order. The steps may be performed in any order.

While the invention has been illustrated and described in detail in the drawings and the foregoing description, such illustrations and descriptions are considered illustrative or exemplary and not restrictive, the invention is not limited to the disclosed embodiments.

Other variations to the disclosed embodiments may be understood and effected by those skilled in the art in practicing the claimed invention, from a study of the drawings, the disclosure and the appended claims.

In the claims, the word "comprising" does not exclude other elements or steps, and the indefinite article "a" or "an" does not exclude a plurality.

A single heat exchange system or a single switching module or cabinet may fulfill the function of several items recited in the claims. The mere fact that certain measures are recited in mutually different dependent claims does not indicate that a combination of these measures may not be used to advantage. Any reference signs in the claims should not be constitute as limiting the scope.

### LIST OF REFERENCE SYMBOLS

- 100: switching cabinet
- 101: housing top side
- 102: housing bottom side
- 103: housing left side
- 104: housing right side
- 105: housing front side
- 106: housing back side
- 110: switching module, circuit breaker
- 111: enclosure top side
- 112: enclosure bottom side
- 113: enclosure left side
- 114: enclosure right side
- 115: enclosure front side
- 116: enclosure back side
- 120: electric and/or electronic component(s)
- 121: thermoconductive electric insulator
- 130: heat source
- 131: first evaporator
- 133: first condenser
- 134: connecting adiabatic conduit
- 135: upper first evaporator conduit
- 136: lower first evaporator conduit
- 137: first condensate conduit
- 138: first vapour conduit
- 140: outer cooling circuit
- 143: first thermoconducting back side
- 150: vertical direction
- 152: horizontal direction
- 154: longitudinal direction
- 200: heat exchanger system
- 210: first cooling circuit
- 212: first interface
- 214: second interface
- 216: third interface
- 218: fourth interface
- 220: second cooling circuit
- 221: second evaporator
- 222: second condenser
- 223: condenser
- 224: second vapour conduit
- 225: second condensate conduit
- 241: second thermoconducting back side
- 400: heat transfer component
- 422: third manifold
- 423: fourth manifold
- 424: second evaporator conduit
- 425: second evaporator mounting holes
- 426: first condenser conduit
- 427: first condenser mounting holes
- 428: first condenser plate
- 429: second evaporator plate
- 431: first channel
- 433: second channel
- 434: first manifold
- 435: second manifold
- 447: sixth manifold
- 448: fifth manifold
- 450: first finned tube heat exchanger
- 451: second finned tube heat exchanger
- 452: first finned tube
- 453: second finned tube
- 454: first fins
- 455: second fins
- 500: heat exchanger
- 502: partially vaporized first coolant
- 503: partially vaporized second coolant
- 504: condensed second coolant
- 505: condensed first coolant
- 600: roll bond panel heat exchanger
- 602: roll bond panel(s)
- 603: vapour conduit portion
- 604: roll bond channel(s)
- 605: condensate conduit portion
- 606: roll bond collector
- 607: roll bond condensate pipe
- 700: cold plate
- 701: cold plate thermoconducting back side
- 702: cold plate conduit
- 703: cold plate channel(s)

## Claims

1. A heat exchanger system (200) for removing heat from a heat source (130) comprising at least one of an electric and an electronic component (120), the heat exchanger system (200) comprising:
a first cooling circuit (210) that is formed as a loop-type thermosiphon comprising a first coolant which at least partially changes phases between a liquid state and a vaporous state in an operating state of the first cooling circuit (210) when heated up above a vaporization point of the first coolant,
wherein the first cooling circuit (210) has a first interface (212) for receiving a thermal load from the heat source (130) that is thermally connectable to the first interface (212), and
wherein the first cooling circuit (210) has a second interface (214) for releasing a major portion of said thermal load,
wherein the first interface (212) acts as a first evaporator (131) and the second interface (214) acts as a first condenser (133) in an operating state of the first cooling circuit (210),
**characterized in that** the heat exchanger system (200) comprises a second cooling circuit (212) that is formed as a loop-type thermosiphon comprising a second coolant which at least partially changes phases between a liquid state and a vaporous state in an operating state of the second cooling circuit (220) when heated up above a vaporization point of the second coolant,
wherein the second cooling circuit (212) has a third interface (216) that is thermally connected to the second interface (214), and
wherein the second cooling circuit (220) has a fourth interface (218) for releasing the major portion of said thermal load taken up at the third interface (216),
wherein the third interface (216) acts as a second evaporator (221) and the fourth interface (218) acts as a second condenser (222) in an operating state of the second cooling circuit (212).

2. The heat exchanger system (200) of claim 1,
wherein the third interface (216) is detachable from the second interface (214).

3. The heat exchanger system (200) of claim 1 or 2
wherein the first condenser (133) is attached to the second evaporator (221) forming a heat exchanger (500) such that the second interface (214) in form of a first thermoconducting back side (143) of the first condenser (133) is thermally connected to the third interface (216) in form of a second thermoconducting back side (241) of the second evaporator (221).

4. The heat exchanger system (200) of claim 3,
wherein the second evaporator (221) has the same design as the first condenser (133).

5. The heat exchanger system (200) of anyone of claims 1 to 4,
wherein the first cooling circuit (210) comprises:
a first manifold (434) fluidly connected to at least one first evaporator conduit (134, 135, 136) of the first evaporator (131) for collecting at least partially vaporized first coolant from the first evaporator (131) in an operating state of the heat exchanger system (200), said first manifold (434) being fluidly connected to at least one first condenser conduit (426) of the first condenser (133) for feeding the at least partially vaporized first coolant to the first condenser (133) in an operating state of the heat exchanger system (200); and
a second manifold (435) fluidly connected to the at least one first condenser conduit (426) for collecting condensed first coolant from the first condenser (133) in an operating state of the heat exchanger system (200), said second manifold (435) being fluidly connected to the at least one first evaporator conduit (134, 135, 136) for feeding the condensed first coolant back to the first evaporator (131) in an operating state of the heat exchanger system (200);
wherein the first manifold (434) is arranged above the second manifold (435) such that in an operating state of the heat exchanger system (200) the condensed first coolant is enabled to move by gravity through the at least one first condenser conduit (426) to the second manifold (435).

6. The heat exchanger system (200) of anyone of claims 1 to 5, further comprising:
a first vapour conduit (138) for guiding at least partially vaporized first coolant from the first evaporator (131) to the first condenser (133);
a first condensate conduit (137) for guiding condensed first coolant from the first condenser (133) to the first evaporator (131);
wherein first vapour conduit (138) and the first condensate conduit (137) are at least partially led coaxially to one another in between the first evaporator (131) and the first condenser (133).

7. The heat exchanger system (200) of any one of the preceding claims,
wherein the first coolant in the first cooling circuit (210) has a first filling ratio, and wherein the second coolant in the second cooling circuit (220) has a second filling ratio which is different from the first filling ratio.

8. The heat exchanger system (200) of any one of the preceding claims,
wherein the first coolant and the second coolant are structurally identical.

9. The heat exchanger system (200) of any one of the preceding claims,
wherein the second interface (214) and the third interface (216) are planar.

10. A switching module (110) having a heat source (130) with at least one of an electric and an electronic component (120), the switching module (110) comprising:
a first cooling circuit (210) that is formed as a loop-type thermosiphon comprising a first coolant which at least partially changes phases between a liquid state and a vaporous state in an operating state of the first cooling circuit (210) when heated up above a vaporization point of the first coolant,
wherein the first cooling circuit (210) has a first interface (212) for receiving a thermal load from the heat source (130) that is thermally connectable to the first interface (212), and
wherein the first cooling circuit (210) has a second interface (214) for releasing a major portion of said thermal load,
wherein the first interface (212) acts as a first evaporator (131) and the second interface (214) acts as a first condenser (133) in an operating state of the first cooling circuit (210).

11. The switching module (110) according to claim 10, comprising:
at least one circuit breaker having a plurality of electric and/or electronic components (120) with different electrical phases;
wherein the first interface (212) is thermally connected to a thermoconductive electric insulator (121) that is thermally connected to the plurality of electric and/or electronic components (120) or to a plurality of thermoconductive electric insulators (121) each of which is thermally connected to one of the plurality of electric and/or electronic components (120).

12. A switching cabinet (100) comprising:
a heat exchanger system (200) of any one of claims 1 to 9, and at least one switching module (110) according to claim 10 or 11,
wherein the second cooling circuit (220) is thermally connected to the first cooling circuit (210), and
wherein the major portion of the thermal load generateable by the heat source (130) is releasable at the fourth interface (218) in an operating state of the heat exchanger system (200).

13. The switching cabinet (100) of claim 12, comprising:
a housing (101, 102, 103, 104, 105, 106);
wherein the fourth interface (218) forming the second condenser (222) is arranged in a peripheral area of the housing (101, 102, 103, 104, 105, 106) or outside the housing (101, 102, 103, 104, 105, 106) with respect to an interior of the switching cabinet (100) that is confined by the housing (101, 102, 103, 104, 105, 106).

14. Method (800) of manufacturing a heat exchanger system (200) according to claims 1 to 9, the method (800) comprising the steps of:
a) thermally connecting (801) the first interface (212) of the first cooling circuit (210) to at least one of an electric and electronic component (120) of the heat source (130);
b) thermally connecting (802) the first interface (212) to the second interface (214) of the first cooling circuit (210);
c) thermally connecting (803) the second interface (214) to the third interface (216) of the second cooling circuit (212);
d) thermally connecting (804) the third interface (216) to the fourth interface (218) of the second cooling circuit (212);
e) filling a first coolant (805) in the first cooling circuit (210);
f) filling a second coolant (806) in the second cooling circuit (212).

15. Use of the heat exchanger system (200) according to any one of claims 1 to 9 for transferring at least a portion of a thermal load from at least one electric and/or electronic component (120) being thermally connected to the first interface (212) to a second condenser (222) in an operating state of the heat exchanger system (200), said second condenser (222) being arranged spatially distanced to the first interface (212).
